# FASCICULE DE BREVET EUROPEEN

(11) **EP 1 828 431 B1**
(45) Date de publication et mention de la délivrance du brevet: **05.08.2020**
(21) Numéro de dépôt: 05850603.1
(22) Date de dépôt: 23.12.2005
(51) Int. Cl.: C23C 16/18, C23C 16/40

(54) **PROCEDE DE PREPARATION DE NANOPARTICULES D'ARGENT OU D'UN ALLIAGE D'ARGENT, DISPERSEES SUR UN SUBSTRAT, PAR DEPOT CHIMIQUE EN PHASE VAPEUR**
VERFAHREN ZUR HERSTELLUNG VON AUF EINEM SUBSTRAT DISPERGIERTEN NANOPARTIKELN AUS SILBER ODER EINER SILBERLEGIERUNG DURCH CVD
METHOD FOR PREPARING NANOPARTICLES OF SILVER OR A SILVER ALLOY, DISPERSED ON A SUBSTRATE, BY CHEMICAL VAPOUR DEPOSITION

(30) Priorité: 23.12.2004 FR 0453179
(43) Date de publication de la demande: 05.09.2007
(73) Titulaire: Commissariat à l'Énergie Atomique et aux Énergies Alternatives, 75015 Paris (FR); Centre National de la Recherche Scientifique, 75016 Paris (FR); UNIVERSITE DE POITIERS, 86034 Poitiers Cedex (FR)
(72) Inventeur: THOLLON, Stéphanie, 38250 St Nizier Du Moucherotte (FR); LUC, Fabien, 38420 Domene (FR); BARRAULT, Joël, F-86240 Liguge (FR); VALANGE, Sabine, F-86240 Liguge (FR); GUELOU, Erwan, F-86000 Poitiers (FR); DATURI, Marco, F-14610 Epron (FR); CAN, Fabien, F-86000 Poitiers (FR)
(74) Mandataire: Ahner, Philippe
(86) Numéro de dépôt international: PCT/FR2005/003264
(87) Numéro de publication internationale: WO 2006/070130

(56) Documents cités:
- US-A1- 2003 039 860
- US-A1- 2003 231 304
- US-B1- 6 238 686
- P SERP ET AL.: "One-Step Preparation of Highly Dispersed Supported Rhodium Catalysts by Low-Temperature Organometallic Chemical Vapor Deposition" JOURNAL OF CATALYSIS, vol. 157, no. 2, décembre 1995 (1995-12), pages 294-300, XP002340803 Duluth, MN, US cité dans la demande
- SERP P ET AL: "SINGLE-STEP PREPARED OF ACTIVATED CARBON SUPPORTED PLATIMUN CATALYSTS BY FLUIDIZED BED ORGANOMETALLIC CHEMICAL VAPOR DEPOSITION" CARBON, ELSEVIER, OXFORD, GB, vol. 37, no. 3, 1999, pages 527-530, XP008065065 ISSN: 0008-6223
- MAKELA J M ET AL: "Generation of metal and metal oxide nanoparticles by liquid flame spray process" JOURNAL OF MATERIALS SCIENCE KLUWER ACADEMIC PUBLISHERS USA, vol. 39, no. 8, 15 avril 2004 (2004-04-15), pages 2783-2788, XP002340802 ISSN: 0022-2461
- DATABASE COMPENDEX [Online] ENGINEERING INFORMATION, INC., NEW YORK, NY, US; 20 mai 2005 (2005-05-20), THOLLON STEPHANIE ET AL: "Pulsed liquid injection metalorganic chemical vapor deposition of metallic nanostructured catalysts. Evaluation of their deVOC catalytic properties" XP002385158 Database accession no. E2006079702542 -& MEET. ABSTR.; MEETING ABSTRACTS; 207TH MEETING OF THE ELECTROCHEMICAL SOCIETY - MEETING ABSTRACTS 2005, 2005, page 87, XP008065077

## Description

### DOMAINE TECHNIQUE

L'invention concerne un procédé de préparation de nanoparticules d'argent ou d'un alliage d'argent, dispersées sur un substrat, par CVD, comme dans la revendication 1

Le domaine technique de l'invention peut être défini de manière générale comme celui de la préparation de nanomatériaux comprenant des nanoparticules d'argent , dispersées sur un substrat ou support que ce dernier soit dense ou poreux.

Ces nanomatériaux trouvent leur application dans les domaines de l'électronique, de l'optique, et surtout de la catalyse notamment pour la protection de l'environnement.

Un domaine d'application particulièrement intéressant de l'invention est celui de l'élimination des polluants tels que les oxydes d'azote NO, et NOₓ se trouvant dans l'air, ces polluants provenant notamment des gaz d'échappements des véhicules automobiles.

En effet, les nouvelles directives européennes visant à réduire drastiquement les rejets de gaz polluants (COV, hydrocarbures, CO, NOₓ...) dans l'air amènent naturellement à rechercher des solutions écologiques et économiques pour satisfaire les normes de rejet. Du fait des contraintes actuelles et futures imposées, entre autres, sur les limites d'émission pour les véhicules particuliers essence et Diesel, ainsi que pour les cheminées des incinérateurs, des cimenteries ou des verreries, la réduction des émissions des NOₓ est devenu un des thèmes de recherche privilégié dans le domaine de la protection de l'environnement. De nombreuses équipes de recherche tant académiques qu'industrielles ont porté attention aux différents paramètres influant directement sur la réaction "deNOₓ", à savoir la nature des supports, des gaz réactifs (CO, H₂, NH₃, hydrocarbures,...) et surtout des systèmes catalytiques mis en oeuvre dans le sprocessus pouvant mener à la diminution, voire l'élimination des NOₓ.

La présente invention s'applique donc notamment au traitement des oxydes d'azote issus principalement des véhicules automobiles, ou des sources stationnaires, et s'inscrit particulièrement dans le cadre de la mise en oeuvre des catalyseurs favorisant la réduction catalytique sélective de NO en présence d'hydrocarbures (appelée couramment procédé h-SCR ou "Lean-deNOₓ), ou bien piégeant les NOₓ sous forme de nitrates et réduction successive, ou éliminant les NOₓ via le procédé à l'ammoniac.

Pour résumer, l'apparition récente des moteurs à injection directe essence dits "Lean-Burn", qui fonctionnent comme les moteurs Diesel en large excès d'oxygène, s'est accompagnée de la mise au point de nouveaux types de convertisseurs catalytiques.

Si l'oxydation catalytique des polluants réducteurs ne pose pas de difficulté au sein du flux gazeux fortement oxydant sortant d'un moteur Diesel, la réduction des NOₓ (en N₂) dans un tel milieu est un problème non résolu à ce jour. Plusieurs systèmes catalytiques sont à l'étude et nécessitent encore une mise au point.

Ceux qui fonctionnent selon le procédé "h-SCR" sont généralement constitués d'une phase métallique (notamment composée d'un ou plusieurs métaux nobles) supportée sur un oxyde métallique qui est généralement un oxyde d'aluminium mélangé à un oxyde de cérium et auxquels sont ajoutés ou non d'autres oxydes de métaux de transition et/ou de la colonne IIIA. L'oxydation d'un agent réducteur, introduit en flux continu ou pulsé, maintient le caractère métallique de la phase supportée, capable de dissocier les oxydes d'azote. Le support, entre autres, aide à l'élimination de l'oxygène issu de la dissociation.

La particularité des catalyseurs dits "NOx-Trap" ou pièges à NOₓ est de fonctionner par alternances successives sous régimes pauvre et riche, la première phase correspondant à l'oxydation et au stockage sous forme de nitrates des NOₓ présents dans les effluents gazeux en sortie du moteur, la deuxième à leur réduction. Cette voie est, à ce jour, présentée comme la plus attractive dans le domaine de la dépollution automobile puisque faisant appel à un mélange réactif proche de celui présent en sortie de la chambre de combustion des moteurs Diesel et apparaît par ailleurs beaucoup plus économique en réducteur.

Le choix des métaux lors de l'élaboration des catalyseurs "deNOₓ" et "NOₓ-Trap" s'est fait parmi différents éléments du groupe VIII de la classification périodique, et plus précisément entre le palladiuim, le platine et le rhodium. Classiquement, on retrouve une combinaison entre le Pt et le Rh, le Pt étant supposé intervenir dans les réactions d'oxydation (du monoxyde d'azote lors de la phase pauvre et dans le procédé SCR à l'ammoniac, des agents réducteurs lors de la phase riche ou réductrice), tandis que le rhodium interviendrait principalement dans les réactions de réduction du NO, et du NO₂ pour donner N₂. Ces métaux joueraient également un rôle lors de la phase riche dans les processus de décomposition des espèces stockées (nitrates) sur les catalyeurs NOₓ-Trap.

Les métaux peuvent être amenés à être déposés avec ou sur un oxyde qui joue le rôle de l'adsorbant dans les catalyseurs NOₓ-Trap ou d'échangeur d'oxygène pour les autres cas : pour résumer, son rôle, dans le premier cas, est à la foi de stocker les NOₓ lors de la phase pauvre, et de permettre leur réduction lors des périodes riches [1]. Pour ce faire, les matériaux les plus adéquats sont les alcalins et les alcalino-terreux (Ca, Sr, Ba, K ou Na), du fait soit de leur faible électronégativité, soit de leur forte basicité. En effet, plus la basicité de l'élément considéré est forte, plus son affinité vis-à-vis des NOₓ est importante. Pour cette raison, les éléments les plus couramment utilisés sont le baryum et le strontium. Dans le deuxième cas, l'oxyde constitue un réservoir d'oxygène pour l'oxydation. Il doit donc présenter d'excellentes propriétés d'échange d'O₂, comme c'est le cas pour les systèmes de base de terres rares, telles que Ce, Pr,..., ou d'éléments de transition tels que Mn, Fe, Co, Ni....

La réduction catalytique sélective des oxydes d'azote via l'ammoniac ou l'urée est, par contre, actuellement utilisée pour la dépollution des effluents issus de sources fixes via les réactions :

4 NO + 4 NH₃ + O₂ → 4 N₂ + 6 H₂O

ou

2 NO + 2 NO₂ + 4 NH₃ → 4 N₂ + 6 H₂O

Les matériaux catalytiques utilisés sont des oxydes de titane supportant du vanadium, du molybdène et du tungstène, ou des zéolithes. Leurs inconvénients sont dus à l'instabilité de la phase active et du support en conditions extrêmes d'utilisation, ou suite au vieillissement, et aux fuites d'ammoniac. Pour éviter cela, il a été récemment envisagé de stocker l'ammoniac dans une matrice zéolithique et de la faire réagir ensuite avec le flux contenant les NOₓ [2]. Pour que ce procédé soit efficace, une proportion importante de NO₂ dans le flux réactionnel est indispensable, d'où la nécessité d'oxyder en partie NO à NO₂ à la température de la réaction.

Outre la nature du métal ou de l'alliage métallique, l'optimisation de la teneur et de la dispersion est essentielle lors de l'élaboration des catalyseurs, puisqu'elle conditionne l'efficacité de ces matériaux dans les réactions de SCR.

Des études précises ont porté sur la relation entre l'activité en conversion des NOₓ et la taille des particules métalliques réalisées par imprégnation/séchage/calcination. Pour exemple, OLSSON et al. [3] observent pour leur part que plus les particules de platine sont grosses (centaine de nm de diamètre) et dispersées, plus l'oxydation de NO en NO₂ est favorisée. D'autres études récentes faisant état des résultats catalytiques dans la réaction "deNOₓ" avec des catalyseurs à base d'argent montrent que l'influence de la forme chimique et de la teneur en Ag est importante : les meilleures performances "deNOₓ" ont été obtenues pour de faibles taux de chargement (1 à 3 % mass.), lorsque le catalyseur Ag est présent principalement dans un état d'oxydation +1. Dans ces deux exemples, les catalyseurs favorisent l'oxydation de NO en espèces ad-NOₓ qui réagissent par la suite pour former des espèces réactives intermédiaires telles que NO₂, nitrates,..., susceptibles de se convertir en N₂.

On sait par ailleurs que les propriétés d'un métal changent lorsque les particules ont une taille dans la gamme des nanomètres. Des métaux nobles tels que l'Au, le Pt, l'Ir, deviennent très réactifs lorsqu'ils atteignent la taille du nanomètre.

En particulier, du fait du plus faible coût des précurseurs à base d'argent et du fort potentiel catalytique des matériaux à base de ce métal, les catalyseurs à base d'argent ont fait l'objet d'une attention particulière et il a été montré que leur efficacité catalytique était très sensiblement accrue par suite d'une augmentation de leur dispersion et donc d'une diminution de la taille des particules.

A titre d'exemple, des nanoparticules d'argent d'une taille de 7 à 15 nm préparées par réduction de AgNO₃ ou de AgClO₄ en solution aqueuse avec un réducteur doux tel que NaBH₄, N₂H₄, ou l'acide ascorbique ont de très bonnes performances dans le procédé de réduction des composés nitroaromatiques en amines en milieu aqueux.

Habituellement l'imprégnation est le procédé principal pour préparer les catalyseurs métalliques supportés à base d'argent ou non, tels que ceux qui servent à la conversion des oxydes d'azote NOₓ, mais ce procédé requiert plusieurs étapes comprenant des réductions et des oxydations à haute température. Ce procédé fournit des tailles d'agrégat voisines de 1 à 10 µm.

Outre l'imprégnation, les catalyseurs actuellement mis en oeuvre et développés, sont déposés par d'autres procédés classiques de préparation, tels que la voie sol-gel, la coprécipitation et autres,.... Les catalyseurs préparés par tous ces procédés classiques (imprégnation, voie sol-gel, coprécipitation) présentent, par exemple, des activités de conversion des NOₓ dans une gamme de température généralement comprise entre 300°C et 500°C. Néanmoins, de réelles difficultés sont recontrées quant à la maîtrise de la taille des nanoparticules, notamment pour ce qui concerne les particules de taille, diamètre, inférieur à 50 nm ; ainsi que de leur dispersion, ce qui influe ainsi négativement sur les rendements de catalyse et les températures d'activation.

Un autre procédé permettant le dépôt d'un métal sur un substrat est le procédé dit de dépôt chimique en phase vapeur d'organométalliques (« OMCVD » ou « Organometallic Chemical, Vapour Déposition » en anglais). Ce procédé présente de nombreux avantages par rapport à des procédés tels que l'imprégnation, ou l'électrodéposition ou encore par rapport aux technologies de dépôt physique en phase vapeur (« Physical Vapour Déposition » ou « PVD » en anglais). En effet, le procédé d'OMCVD permet de recouvrir les pièces de géométries complexes telles que les supports catalytiques par exemples les mousses, nids d'abeille, céramiques, zéolithes sans qu'il soit nécessaire de travailler dans des domaines de vide poussé, à savoir de 100 à 500 Pa ; ce qui en fait un procédé facilement industrialisable lorsqu'on le compare au procédé de dépôt physique en phase vapeur (« PVD ») par exemple.

En outre, le procédé de dépôt « OMCVD » est un procédé que l'on peut qualifier de « propre » qui génère peu d'effluents liquides ou gazeux au contraire notamment de l'électrodéposition qui est un procédé très polluant.

Le procédé d'OMCVD permet notamment de préparer des nanomatériaux catalytiques performants. Ainsi, le document de P. SERP, R. FEURER, R. MORANCHO, P. KALCK, Journal of Catalysis, 157 (1995), 294-300 décrit la préparation en une étape de catalyseurs comprenant des nanoparticules de palladium fortement dispersées par OMCVD à basse température sur des substrats en silice en présence d'une atmosphère d'hélium et d'hydrogène. Ces catalyseurs présentent une meilleure activité catalytique pour l'hydrogénation ques les catalyseurs déposés par une technique d'imprégnation classique.

Dans le cas particulier de l'argent, les procédés de CVD en général et notamment les procédés de OMCVD n'ont permis jusqu'à présent que le dépôt de couches continues, c'est-à-dire recouvrant la totalité du substrat sur laquelle elles sont déposées.

En d'autres termes, concernant les procédés de dépôt en phase vapeur de films d'argent, les rares travaux scientifiques disponibles sur ce sujet relatent seulement la synthèse de couches minces continues d'argent conductrices sur des substrats plans qui sont principalement utilisés dans les domaines de l'électronique, de l'optique et du magnétisme.

Ainsi, le document de SAMOILENKOV et al., Chemical Vapour Déposition, 8(2) (2002), 74, décrit un procédé de dépôt de films d'argent épais par OMCVD. Les dépôts obtenus se présentent sous la forme de films continus ou sous la forme d'îlots d'un diamètre supérieur à 1 µm, du fait des températures élevées de synthèse qui dépassent 500°C.

De même, le document FR-A-2 852 971 décrit un procédé pour le dépôt par CVD d'un film d'argent sur un substrat, notamment un substrat semiconducteur. Le dépôt est effectué à l'aide d'une solution d'un précurseur d'argent qui est un carboxylate d'argent - le pivalate d'argent étant préféré - dissout dans un solvant tel que le mésitylène, le cyclohexane, le xylène, le toluène et le n-octane. Une amine ou un nitrile est ajouté dans la solution afin de favoriser la dissolution du précurseur.

L'enceinte de dépôt est sous atmosphère d'hydrogène ou d'oxygène, c'est-à-dire que l'hydrogène bu l'oxygène est introduit dans l'enceinte de dépôt sous forme d'un mélange avec N₂ dans lequel le rapport en volume H₂/N₂ ou O₂/N₂ est inférieur ou égal à 1. Cela signifie que le gaz réactif (O₂ ou H₂) est en minorité dans le mélange gazeux.

Ce procédé permet l'obtention de couches continues fines (d'une épaisseur inférieure ou égale à 50 nm), ou épaisses (d'une épaisseur de 50 nm à 1 µm).

Dans les exemples, on utilise des rapports de débit O₂/N₂ de 0,075 (Exemples 1 et 2) ; et 0,8875 (exemple 4) et l'on obtient dans tous les cas des films d'argent continus. Ce procédé ne permet donc pas de préparer des nanoparticules d'argent dispersées sur un substrat.

Il existe donc au vu de ce qui précède, de manière générale, un besoin pour un procédé de préparation, de dépôt, de nanoparticules de métal ou d'alliage de métaux, sur un substrat, qui permette de moduler, maîtriser, la taille, morphologie des nanoparticules de métal ou d'alliage ainsi que leur dispersion, concentration sur ledit substrat.

Il existe encore un besoin pour un procédé de préparation, de dépôt, de nanoparticules de métal ou d'alliage de métaux sur un substrat qui, utilisé comme catalyseur, par exemple, pour les réactions d'élimination des oxydes d'azote NOₓ, présente une efficacité catalytique accrue, en termes notamment de rendement, de sélectivité et de température d'activation, ainsi qu'une durée de vie augmentée.

Ce procédé doit, par ailleurs, être simple, fiable, et peu coûteux, financièrement et énergétiquement.

Il existe en particulier un besoin non encore satisfait pour un procédé permettant de déposer des nanoparticules d'argent dispersées sur un substrat par dépôt chimique en phase vapeur.

Le but de l'invention est, entre autres, de répondre à ces besoins.

Ce but, et d'autres encore, sont atteints, conformément à l'invention, par un procédé de dépôt de nanoparticules d'argent dispersées sur un substrat, par dépôt chimique en phase vapeur CVD, à partir d'un ou plusieurs précurseurs organométalliques comprenant au moins un précurseur organométallique de l'argent , dans lequel le dépôt est réalisé en présence d'un gaz comprenant plus de 50% en volume d'un gaz réactif oxydant.

Dans le cas de nanoparticules d'un alliage celui-ci est de préférence choisi parmi les alliages d'argent avec des métaux des colonnes VIIIB et IB du tableau périodique, tels que Rh, Pt, Pd et Ir.

Avantageusement, les nanoparticules sont incluses dans une matrice d'oxyde de métal, ledit oxyde étant choisi par exemple parmi les oxydes de métaux alcalins, de métaux alcalino-terreux, de métaux de transition ou de terres rares, tels que Ca, Sr, Ba, K, Na, Ce, Pr, Mn, Fe, Co, Ni,... ; ou de carbone ; ou sont associées à une zéolithe.

Avantageusement le gaz en présence duquel est réalisé le dépôt comprend plus de 70%, de préférence 100%, en volume du gaz réactif oxydant.

Le gaz réactif oxydant peut être choisi parmi l'oxygène, le dioxyde de carbone, l'ozone, le N₂O, et leurs mélanges.

Le gaz en présence duquel est réalisé le dépôt peut être constitué par un mélange du gaz oxydant et d'un gaz inerte.

Le gaz inerte peut être choisi parmi l'argon, l'azote, l'hélium, et leurs mélanges.

Dans ledit mélange de gaz oxydant et d'un gaz inerte, le rapport des débits gaz oxydant/gaz inerte est (strictement) supérieur à 1, ce qui correspond à la condition mentionnée ci-dessus selon laquelle dans le procédé de l'invention le gaz oxydant est présent à plus de 50% en volume dans le mélange gazeux en présence duquel est réalisé le dépôt.

Le procédé selon l'invention se distingue fondamentalement des procédés de l'art antérieur pour le dépôt d'argent, par OMCVD sur un substrat car, de manière fondamentale, selon l'invention, le dépôt d'argent ou d'alliage d'argent, est réalisé en présence d'un gaz - appelé gaz réactionnel - qui comprend en majorité un gaz réactif oxydant tel que l'oxygène, le CO₂ ou un mélange de ceux-ci.

En d'autres termes, ledit gaz réactionnel est composé à plus de 50% en volume d'un gaz réactif oxydant.

Lorsque le gaz en présence duquel est réalisé le dépôt est constitué, par un mélange de gaz oxydant et d'un gaz inerte cette condition s'exprime par le fait que le rapport des débits gaz oxydant/gaz inerte est supérieur à 1 alors que dans le document FR-A-2 852 971, ce rapport est inférieur ou égal à 1.

De manière générale, le procédé selon l'invention permet de déposer des métaux ou alliages jouant, par exemple, le rôle de catalyseurs au sein de structures complexes en surface (2D) ou en volume (3D), sans l'emploi de phase liquide. Les métaux ou alliages catalyseurs se présentent sous forme de particules de taille nanométrique (par exemple de 1 à 100 nm de diamètre) bien dispersées, en particulier, en surface du support (dense ou poreux).

Selon l'invention, la maîtrise des paramètres d'élaboration (tels que la nature des gaz, les paramètres d'injection, la pression) permet d'élaborer des films discontinus à des températures de dépôt relativement basses (par exemple souvent inférieures à 400°C). Le film poreux ainsi obtenu peut se présenter sous la forme d'ilôts métalliques de taille nanométrique par exemple souvent de l'ordre de 1 à 100 nm de diamètre) bien dispersés en surface du support (dense ou poreux), ce qui leur confère une grande surface active. La technique de synthèse selon l'invention permet d'élaborer des couches dont la composition, et en particulier la porosité peuvent être ajustées par certains paramètres du procédé, tels que la nature et le débit de gaz réactif, quantité de précurseur, température, pression,..., influant directement sur la taille et la dispersion des nanoparticules qui sont des facteurs primordiaux pour les applications catalytiques.

Dans le cas notamment ou : l'argent ou les alliages d'argent jouent le rôle de catalyseur, la maîtrise des conditions de dépôt, grâce au procédé de l'invention, permet de moduler la morphologie (taille) et la concentration (dispersion) des agrégats de catalyseurs. L'activité du dépôt catalytique obtenu est étroitement liée à ces deux paramètres, cela se traduit suivant le système étudié par un abaissement des températures de réaction ou encore par une modification de la cinétique des réactions. Enfin, la capacité d'une part de localiser le catalyseur dans le volume des pièces et d'autre part de le disperser à l'échelle nanométrique permet un abaissement significatif du taux de chargement en phase active et donc du coût des dispositifs, surtout pour ceux utilisant des métaux nobles.

Le procédé selon l'invention permet notamment, de manière surprenante, de préparer par la technique de l'OMCVD des nanoparticules d'argent ou d'alliage d'argent dispersées à la surface du substrat, alors que dans l'art antérieur représenté par exemple par le document FR-A-2 852 971, il n'est possible de préparer que des films, couches, continues qui recouvrent la totalité de la surface du substrat.

Pour la première fois, grâce au procédé selon l'invention, on a pu préparer par la technique de l'« OMCVD » des nanoparticules à base d'argent ou d'un alliage d'argent, sur un substrat, quel que soit le type de ce dernier. Ces particules sont très bien dispersées à la surface du substrat, support. Cette excellente dispersion est liée notamment à la faible taille, nanométrique, des particules déposées par le procédé de l'invention.

La taille est définie par la plus grande dimension des particules dispersées ; dans le cas des particules sphériques ou sensiblement sphériques, la taille est définie par le diamètre des particules.

Par taille « nanométrique », on entend que les particules déposées par le procédé de l'invention ont généralement une taille de 1 à 400 nm, de préférence de 1 à 200 nm, de préférence encore de 1 à 100 nm, mieux de 5 à 50 nm.

On peut aussi dire que le procédé selon l'invention permet de préparer (dans certains cas) des films poreux, discontinus, qui se présentent sous la forme d'îlots métalliques, par exemple d'argent, de taille nanométrique très bien dispersés à la surface du substrat, la signification des termes « taille nanométrique » ayant déjà été définie plus haut.

Un film poreux, discontinu est obtenu dans le cas où l'on observe une certaine coalescence des particules.

Dans tous les cas, on n'obtient pas selon l'invention un film continu mais bien un dépôt de particules individuelles, notamment d'argent, dispersées se rejoignant éventuellement par un phénomène de coalescence pour former alors des agrégats de taille plus importante si bien que le dépôt peut alors être qualifié de film poreux, ou discontinu, avec une portion de la surface du substrat qui est toujours exempte de dépôt de particules, et qui reste exposée.

Il a été mis en évidence de manière surprenante, selon l'invention, que le fait de réaliser le dépôt en présence d'une atmosphère spécifique comprenant une proportion majoritaire en volume de gaz oxydant conduisait de manière étonnante, dans le cas de l'agent, à la formation de particules, d'argent, et non d'un film continu, ces particules présentant en outre une taille spécifique, nanométrique, bien plus faible que dans certains procédés de l'art antérieur. En conséquence, ces particules, d'argent, présentent de plus une dispersion sur le substrat beaucoup plus grande que dans l'art antérieur.

Rien ne pouvant laisser supposer à la lecture de l'art antérieur concernant le dépôt de particules d'argent, qu'en utilisant l'atmosphère de gaz spécifique du procédé selon l'invention, on pourrait obtenir au lieu d'un dépôt continu, uniforme, un dépôt sous la forme de particules, notamment d'argent, de taille spécifique, faible, nanométrique, ces particules étant en outre très bien dispersées.

A titre d'exemple, la densité du dépôt des nanoparticules selon l'invention est généralement de 10à 500 particules par µm², de préférence de 50 à 200 particules par µm².

Outre les avantages spécifiques du procédé de l'invention mentionnés ci-dessus, le procédé selon l'invention possède également tous les avantages inhérents au procédé OMCVD : le dépôt est possible sur tout substrat quelle que soit la géométrie même très complexe de celui-ci, quel que soit son état de surface, lisse ou rugueux, et quelle que soit la nature du matériau constituant le substrat, en effet, le dépôt étant réalisé à température relativement basse par exemple inférieure à 300°C, même des substrats en des matériaux sensibles à la chaleur peuvent recevoir un dépôt par le procédé de l'invention.

Par exemple, le procédé selon l'invention permet le dépôt de particules d'alliages d'argent ou de particules d'argent, sur des substrats présentant des géométries aussi complexes que celles utilisées dans le domaine du traitement des effluents gazeux qui se présentent par exemple sous la forme de mousses ou de nids d'abeille céramiques.

Le procédé selon l'invention est facile à mettre en œuvre dans l'industrie, ne nécessite pas généralement de vide poussé, et est peu polluant, en particulier lorsqu'on le compare à des procédés tels que l'électrodéposition.

Les nanoparticules dispersées selon l'invention sont en particulier des nanoparticules d'argent, avec incorporation éventuelle de carbone et/ou d'oxygène, ou des nanoparticules d'un alliage d'argent, avec de même incorporation éventuelle de carbone et/ou d'oxygène.

Ainsi, l'alliage d'argent peut être choisi parmi les alliages d'argent avec au moins un élément choisi parmi les autres métaux (différents de Ag), éventuellement oxydés, et le carbone.

Un autre avantage du procédé selon l'invention est sa grande souplesse car il peut en effet déposer outre l'argent, pratiquement tous les types de métaux ou oxydes de ceux-ci. On dispose donc d'une grande palette de choix en ce qui concerne le choix de l'élément allié éventuel : carbone, métal noble ou non, oxydé ou non.

De préférence, les autres métaux alliés à l'argent sont choisis parmi les métaux nobles tels que le platine, le palladium, le rhodium et l'iridium.

On peut selon l'invention préparer des particules d'alliages binaires, par exemple de Ag/Rh des particules d'alliages ternaires, tels que Ag/Pt/Rh, des particules composites comprenant au moins un métal et au moins un oxyde.

Ledit oxyde pouvant être choisi parmi les oxydes déjà mentionnés plus haut, tels que les oxydes de métaux alcalins, alcalino-terreux, de transition, de terres rares. Par ailleurs, on peut déposer selon le procédé de l'invention uniquement des particules d'un seul métal ou bien on peut déposer simultanément plusieurs particules différentes dont chacune est constituée par un métal ou un alliage différent.

Les précurseurs sont des composés organométalliques (qu'il s'agisse des précurseurs de l'argent, ou des précurseurs éventuels des autres métaux formant un alliage avec l'argent) qui peuvent être solides ou liquides. D'autres précurseurs sont notamment les nitrates de métaux.

Les précurseurs organométalliques sont choisis généralement parmi les carboxylates de métaux et les β-dicétonates de métaux.

Il est bien évident que lorsque l'on souhaite préparer des nanoparticules d'argent ou d'un alliage d'argent, les précurseurs organométalliques comprennent alors obligatoirement au moins un précurseur de l'argent.

Par exemple, le précurseur de l'argent est choisi généralement parmi les carboxylates d'argent de formule RCO₂Ag, dans laquelle R représente un groupe alkyle linéaire ou ramifié de 1 à 10 atomes de carbone, de préférence de 3 à 7 atomes de carbone ; et les β-dicétonates d'argent tels que le tétraméthyl heptanedionate d'argent.

De préférence, le précurseur de l'argent est le pivalate d'argent.

Avantageusement, le ou les précurseurs organométalliques sont mis en œuvre sous la forme d'une solution de ce ou de ces précurseurs dans un solvant organique qui est généralement injecté dans une enceinte fermée où est placé le substrat.

La concentration du ou des précurseurs dans la solution est généralement de 0,01 à 0,6 mol/1.

Ladite solution, contient au moins un précurseur de l'argent, peut avantageusement comprendre une amine et/ou un nitrile afin de faciliter la dissolution du ou des précurseurs de l'argent.

La concentration de l'amine et/ou du nitrile dans la solution est généralement supérieure à 0,1% en volume, de préférence cette concentration en amine et/ou en nitrile est de 0,5 à 10% en volume.

Le solvant de ladite solution est généralement choisi parmi les solvants dont la température d'évaporation est inférieure à la température de décomposition du ou des précurseurs.

Le solvant est choisi de préférence parmi les composés organiques liquides à la température ambiante et jusqu'à 200°C dans les conditions normales de pression tels que le mésitylène, le cyclohexane, le xylène, le toluène, le n-octane, l'acétylacétone, l'éthanol ; l'eau ; et leurs mélanges.

L'amine éventuellement incluse dans la solution est généralement choisie parmi les monoamines primaires, secondaires ou tertiaires telles que la n-hexylamine, l'isobutylamine, la disecbutylamine, la triéthylamine, la benzylamine, l'éthanolamine, et la diisopropylamine ; les polyamines ; et leurs mélanges.

Le nitrile éventuellement inclus dans la solution est généralement choisi parmi l'acétonitrile, le valéronitrile, le benzonitrile, le propionitrile et leurs mélanges.

Le dépôt est généralement réalisé à une température basse, c'est-à-dire à une température du substrat inférieure ou égale à 500°C, de préférence inférieure ou égale à 400°C, de préférence encore inférieure ou égale à 300°C, mieux de 250 à 290°C.

C'est là un avantage supplémentaire du procédé selon l'invention que de permettre le dépôt de particules à une température basse compatible avec un grand nombre de substrats.

Le dépôt peut être réalisé à la pression atmosphérique mais il peut être aussi réalisé sous vide, à une pression par exemple de 300 à 1000 Pa, ce qui est un vide peu poussé, facile à réaliser.

La durée du dépôt est généralement de 2 à 90 minutes, de préférence de 5 à 30 minutes.

Le dépôt peut avantageusement être réalisé avec une assistance, excitation, plasma, telle que "BF", "RF" ou "dc pulsé".

Le substrat est choisi généralement parmi les substrats poreux et les substrats denses.

Le substrat est généralement en un matériau choisi parmi les céramiques telles que l'alumine, la cérine, la zircone ; le silicium ; les zéolithes ; l'acier ; les tissus. Il est divulgué également un substrat comprenant au moins une surface sur laquelle sont dispersées des nanoparticules d'argent ou d'un alliage d'argent.

Du carbone et/ou de l'oxygène peuvent être éventuellement incorporés dans lesdites particules par exemple à raison de 1% atomique.

Généralement, lesdites nanoparticules dispersées ont une taille de 1 à 400 nm, de préférence de 1 à 200 nm, de préférence encore de 1 à 100 nm, mieux de 5 à 50 nm.

Généralement, lesdites nanoparticules ont une densité, sur la surface du substrat de 10 à 500 µm⁻², de préférence de 50 à 200 µm⁻².

Il est possible que certaines des particules se rejoignent pour former ainsi un film discontinu, poreux, sur la surface du substrat.

Lesdits substrats peuvent être utilisés comme éléments de dispositifs optiques ou électroniques mais leur utilisation préférée est dans le domaine de la catalyse. Du fait notamment de la dispersion élevée des particules et de leur faible taille, les substrats selon l'invention que l'on peut définir comme des catalyseurs nanostructurés ont une activité catalytique très élevée, supérieure aux catalyseurs de l'art antérieur, notamment aux catalyseurs à base d'argent de l'art antérieur qui sont peu dispersées et peu actifs.

Cette activité catalytique est présente même à basse température. En fait, les catalyseurs constitués par les substrats selon l'invention, en particulier dans le cas où ils sont à base d'argent, peuvent avoir une activité comparable à celle des catalyseurs à base de platine mais avec l'avantage décisif que l'argent est beaucoup moins cher et beaucoup moins rare que le platine.

En d'autres termes, les propriétés avantageuses des substrats et en particulier des substrats jouant le rôle de catalyseur selon l'invention proviennent intrinsèquement du procédé de préparation, de dépôt, de nanoparticules selon l'invention.

Ces propriétés avantageuses des substrats en particulier des substrats jouant le rôle de catalyseur découlent notamment de la nanostructuration induite par le procédé de synthèse selon l'invention.

En effet, la synthèse de matériaux nanostructurés via le procédé de dépôt chimique en phase vapeur permet d'accroître très fortement l'efficacité catalytique par l'augmentation de plusieurs ordres de grandeur du nombre de sites actifs et par la formation de composés mixtes, tels qu'alliages et composites qui sont définis plus facilement que par des procédés classiques de préparation. La capacité d'une part de localiser le catalyseur dans le volume des pièces et d'autres, part de le disperser à l'échelle nanométrique permet par ailleurs un abaissement significatif du taux de chargement en catalyseur, qui peut être par exemple de l'ordre de 10 fois inférieur par rapport à un procédé traditionnel tel que l'imprégnation et donc un abaissement du coût des dispositifs, surtout pour ceux utilisant des métaux nobles tels que le platine, le rhodium,....

Par réaliser, le procédé selon l'invention et les substrats préparés par ce procédé peuvent permettre d'envisager un saut technologique en combinant les avantages suivants :
- diminution du coût du système catalytique : la capacité d'une part de diminuer de façon conséquente le taux de chargement en catalyseur et d'autre part de travailler sur la nature chimique des systèmes engagés (remplacement des métaux nobles par des métaux non nobles ou oxydes) permet d'abaisser significativement le coût du système (avec gain escompté de l'ordre de 5 %) ;
- diminution des coûts énergétiques : les résultats issus de caractérisations réalisées sur des catalyseurs nanostructurés déposés par CVD permettent de penser que l'efficacité catalytique en terme de rendement et de sélectivité ainsi qu'en terme de température d'activation des réactions catalytiques (gain en température d'au minimum 100°C) sera largement améliorée par rapport aux technologies existantes, diminuant ainsi les coûts énergétiques : à titre d'exemple, le fait d'initier les réactions d'oxydation du NO en NO₂ à des températures proches de 200°C a pour conséquence directe de réduire drastiquement la consommation en carburant et la production de CO₂ : à titre indicatif, une diminution de l'ordre de 50 % du surcroît de consommation en carburant peut être escomptée ;
- gain en terme de durée de vie : un autre avantage d'une basse température de réaction, hormis la plus faible dépense énergétique, est de limiter la désactivation des catalyseurs en évitant leur frittage ou leur dégradation thermique.
Il est divulgué aussi l'utilisation du substrat décrit plus haut pour catalyser une réaction chimique.

Cette réaction chimique peut être toute réaction connue susceptible d'être catalysée par un catalyseur à base d'un des métaux ou alliages de métaux cités plus haut, tels que l'argent.

Il peut s'agir par exemple d'une réaction en phase gazeuse comme une réaction d'oxydation, de préférence sélective, telle que l'oxydation du méthanol, l'époxydation d'oléfines, l'oxydation ménagée d'hydrocarbures, l'oxydation du CO, la décomposition du N₂O, le réformage d'alcools légers tels que le méthanol et l'éthanol, ou un reformage de gaz par exemple dans les piles à combustible, ou une réaction pour réaliser la dépollution de l'air.

Il peut s'agir d'une réaction en phase liquide, notamment en phase aqueuse, par exemple pour réaliser la dépollution de l'eau.

Les substrats peuvent aussi être utilisés comme membranes pour la perméation à l'hydrogène, pour catalyser les réactions d'hydrogénation/déshydrogénation, ou pour catalyser d'autres réactions se produisant par exemple dans les piles à combustible.

Une utilisation préférée du substrat décrit plus haut dans la catalyse d'une réaction chimique qui est une réaction de décomposition, d'élimination des oxydes d'azote, tels que NOₓ, NO par oxydation et/ou réduction.

En effet, le substrat fournit des systèmes catalytiques performants qui permettent d'accroître sensiblement l'efficacité catalytique des réactions d'élimination des NOₓ, par exemple lors des réactions mises en oeuvre dans des catalyseurs dits "NOₓ-Traps" ou pièges à NOₓ pour véhicules automobiles.

En effet, les substrats qui comme on l'a indiqué ci-dessus peuvent être définis comme des "catalyseurs nanostructurés" à base d'un élément métallique noble tel que Pt, Pd, Rh, Ir... et non noble, tel que Ag, pouvant ou non être inclus dans une matrice d'oxyde (oxyde de métal alcalin alcalino-terreux tel que Ca, Sr, Ba, K ou Na ou de métal de transition, tel que Mn, Fe, Co, Ni ou de terres rares, tel que Ce ou Pr), ou pouvant être associés à une zéolithe, permettent l'élimination des émissions d'oxyde d'azote à basse température, par exemple inférieure à 300°C, et trouvent donc une application directe en tant que catalyseurs dans des procédés tels que :
- l'élimination des NOₓ issus de sources fixes (incinérateurs, cimenteries, verreries, usines électriques,...) par le procédé SCR à l'ammoniac sur matériaux zéolithiques, afin d'obtenir la bonne teneur en NO₂ ;
- l'élimination des NO₂ issus de sources mobiles via un procédé h-SCR, où les nanoparticules de métal peuvent oxyder facilement le réducteur en le rendant ainsi actif et, en même temps, générer des espèces les NOₓ plus oxydées et plus réactives mentionnées ci-dessus ;
- l'élimination des NOₓ issus de sources mobiles via un procédé NOₓ-Trap..., où les nanoparticules de métal peuvent oxyder facilement les NOₓ en nitrates, même à basse température.

L'invention va maintenant être décrite de manière plus détaillée dans la description qui suit, donnée à titre illustratif et non limitatif, faite en référence aux dessins joints, dans lesquels :

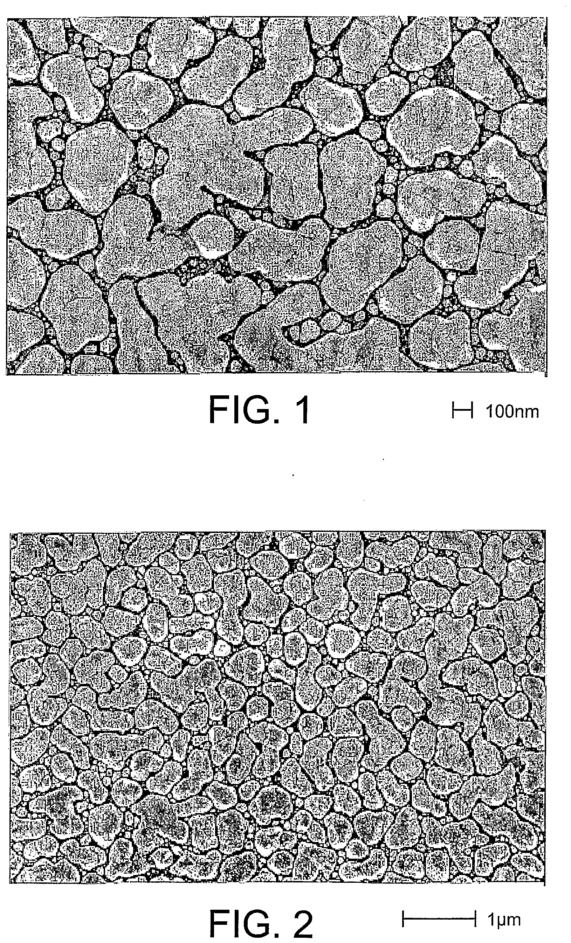

- Les figures 1 et 2 sont des microphotographies réalisées en microscopie électronique à balayage (MEB-FEG) montrant des nanoparticules d'argent préparés par le procédé selon l'invention sur un substrat plan en silicium dans les conditions de l'exemple 1.

Les deux figures montrent le même échantillon mais à des agrandissements différents, à savoir respectivement de 100 000 (Fig. 1) et de 50 000 (Fig. 2).

L'échelle représentée sur la figure 1 est de 100 nm, l'échelle représentée sur la figure 2 est de 1 µm.

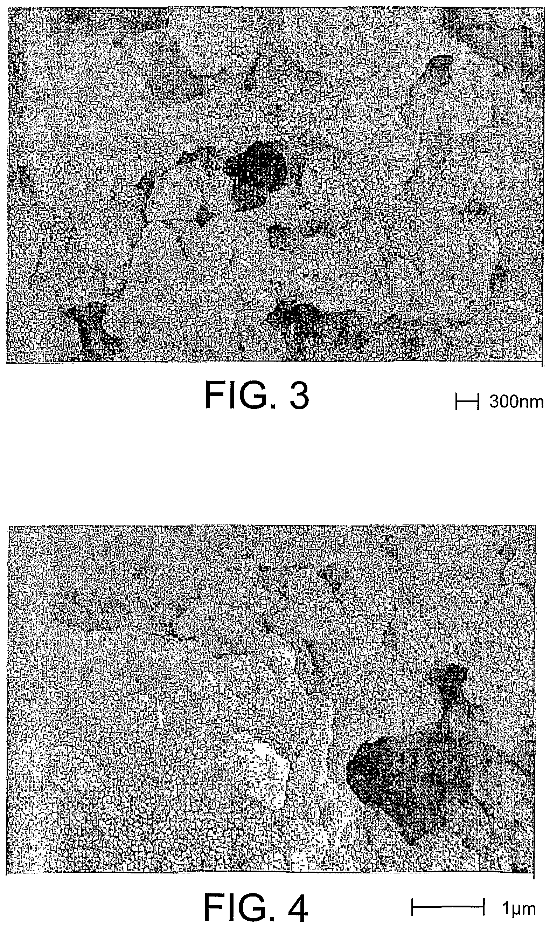

- Les figures 3 et 4 sont des microphotographies réalisées en microscopie électronique à balayage (MEB-FEG) montrant des nanoparticules d'argent préparées par le procédé selon l'invention sur un substrat poreux en mousse céramique alumine-zircone, 20 ppi (« pores par inch » (pouces)), dans les conditions de l'exemple 1.

Les deux figures montrent le même échantillon mais à des agrandissements différents, à savoir respectivement de 50 000 (Fig. 3) et de 50 520 (Fig. 4). L'échelle représentée sur la figure 3 est de 300 nm, tandis que l'échelle représentée sur la figure 4 est de 1 µm.

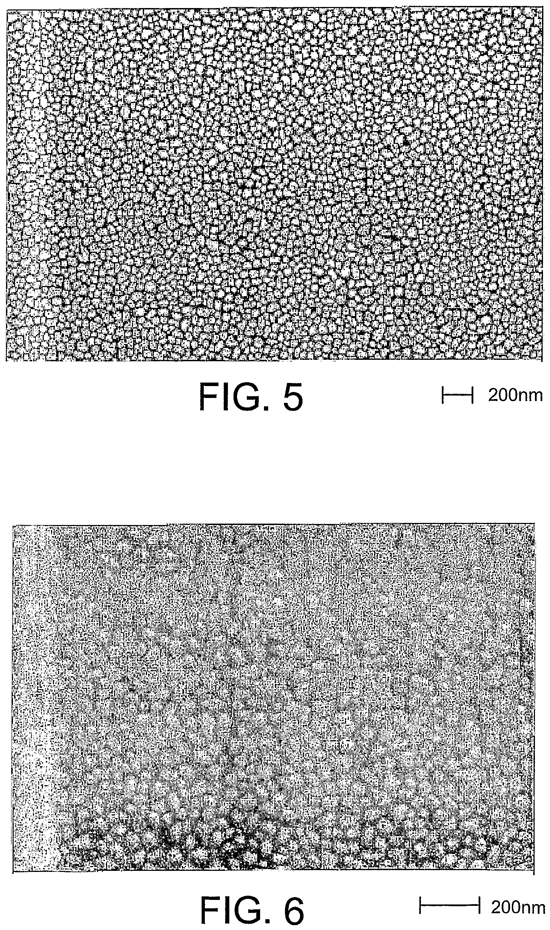

- Les figures 5 et 6 sont des microphotographies réalisées en microscopie électronique à balayage (MEB-FEG) montrant des nanoparticules d'argent préparées par le procédé selon l'invention sur un substrat plan en silicium dans les conditions de l'exemple 2.

Les deux figures montrent le même échantillon mais à des agrandissements différents, à savoir respectivement de 100 000 (Fig. 5) et de 200 000 (Fig. 6). L'échelle représentée sur la figure 5 est de 200 nm et l'échelle représentée sur la figure 6 est également de 200 nm.
- Les figures 7, 8 et 9 sont des microphotographies réalisées en microscopie électronique à balayage (MEB-FEG) montrant des nanoparticules d'argent préparées par le procédé selon l'invention sur un substrat poreux en mousse de céramique alumine-zircone, 20 ppi, dans les conditions de l'exemple 2.

Les trois figures montrent le même échantillon mais à des agrandissements différents, à savoir de 10 000 (Fig. 7), 50 000 (Fig. 8) et 200 000 (Fig. 9).

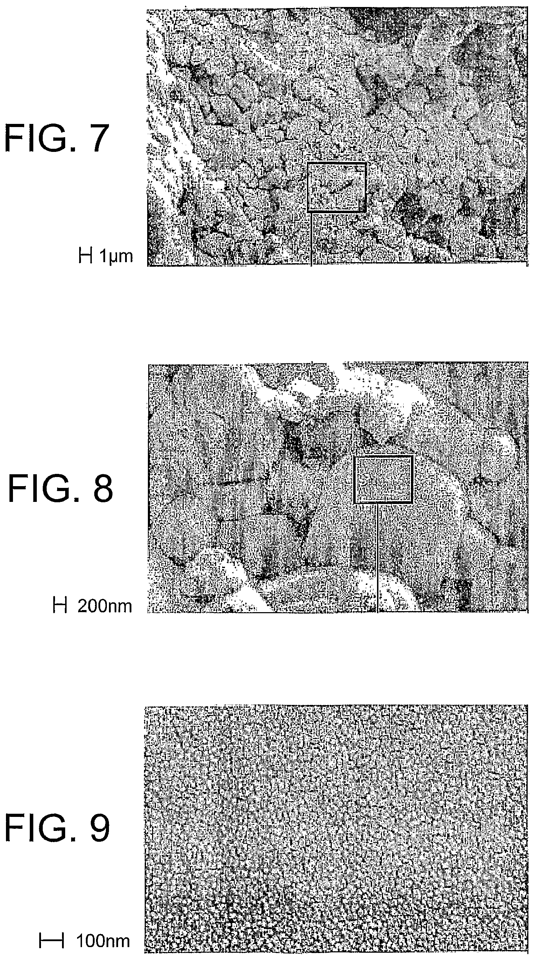

La figure 8 est un agrandissement du cadre représenté sur la figure 7 et la figure 9 est un agrandissement du cadre représenté sur la figure 8.

Les échelles représentées sur les figures 7, 8 et 9 sont respectivement de 1 µm, 200 nm et 100 nm.

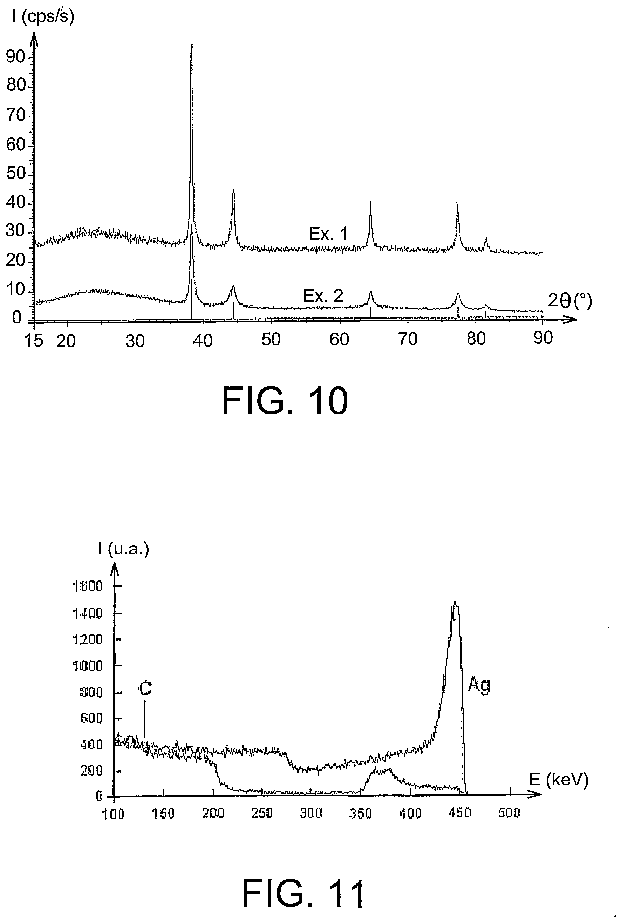

- La figure 10 est un graphique qui représente les diagrammes de diffraction des rayons X des dépôts obtenus conformément au procédé de l'invention dans les exemples 1 (courbe du haut) et 2 (courbe du bas).

En ordonnée est représentée I (cps/s) : l'Intensité en coups par seconde et en abscisse 2θ(°) : l'angle de diffraction.
- La figure 11 est un graphique qui donne les spectres RBS de films d'argent déposés sur des substrats en silicium conformément à l'invention par OMCVD dans les conditions de l'exemple 1 avec une atmosphère oxydante constituée de 10% de N₂ et de 90% O₂, ou dans les conditions de l'exemple 1 mais avec une atmosphère réductrice constituée de 85% en volume de N₂ et de 15% en volume de H₂ (courbe du bas). En ordonnée, est représentée l'intensité I (en unité arbitraire u.a.) et en abscisse est représenté l'énergie (E) en keV.

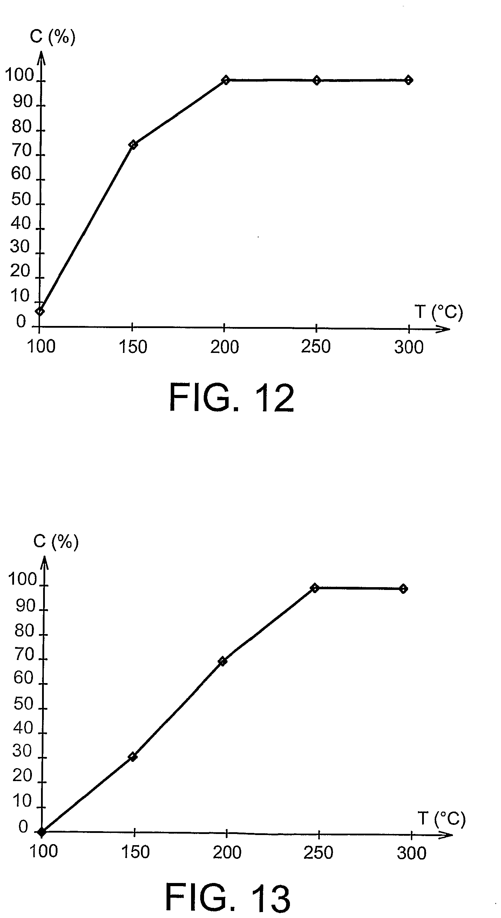

- La figure 12 est un graphique qui donne la conversion C du méthanol (%) en fonction de la température T (°C) dans un procédé de conversion du méthanol à l'aide du film d'argent déposé par OMCVD sur un substrat céramique poreux, (masse alumine-zircone, 20 ppi) dans les conditions de l'exemple 1, en présence d'un gaz constitué de 10% de N₂ et 90% de O₂.
- La figure 13 est un graphique qui donne la conversion (C) en CO₂ (%) en fonction de la température T (°C) dans un procédé de conversion du méthanol à l'aide du même film d'argent que celui mentionné ci-dessus pour la figure 2.

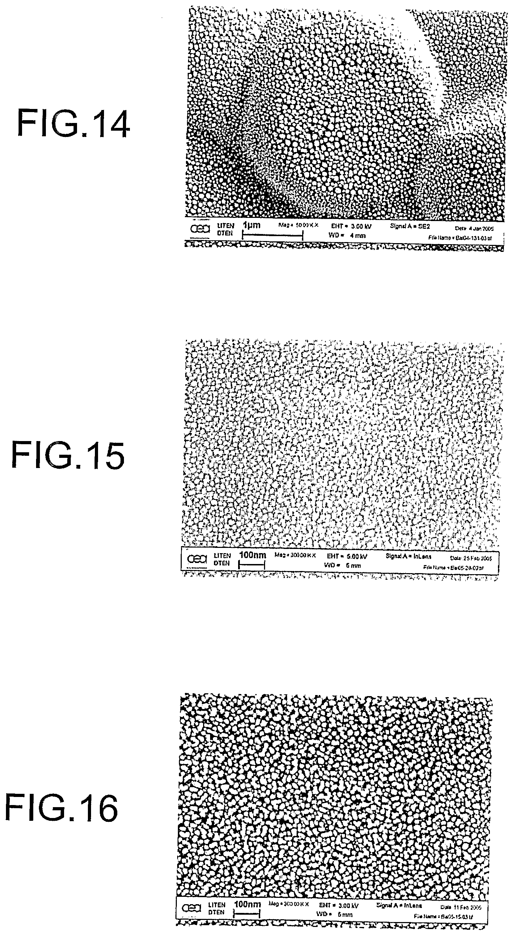

- Les figures 14, 15 sont des microphotographies réalisées en microscopie électronique à balayage (MEB-FEG) montrant respectivement des nanoparticules d'argent préparées par le procédé selon l'invention sur un substrat poreux en mousse de céramique alumine-zircone, 20 ppi, dans les conditions de l'exemple 6 (figure 14) et des nanoparticules d'argent préparées par le procédé selon l'invention sur un substrat plan en silicium dans des conditions de l'exemple 7 (figure 15).

Les échelles représentées sur les figures 14, 15 sont respectivement de 1 µm et 100 nm.
- La figure 16 est une microphotographie réalisée en microscopie électronique à balayage (MEB-FEG) montrant des particules de platine sur un substrat plan en silicium dans les conditions de l'exemple 9.

L'échelle représentée sur la figure 16 est de 100 nm.

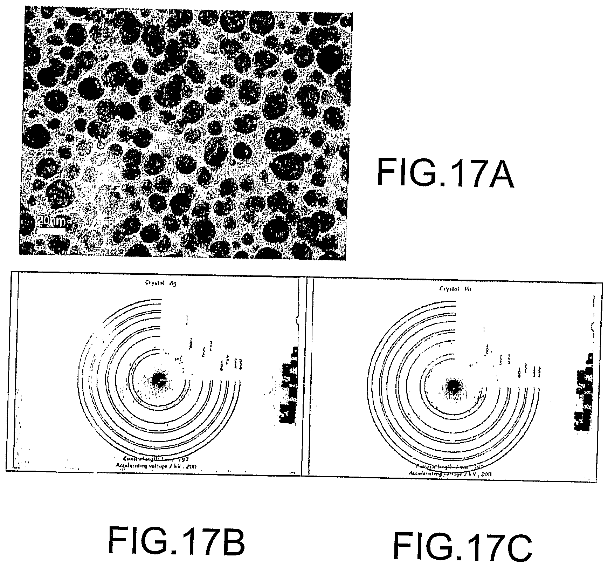

- La figure 17 est une microphotographie réalisée en microscopie électronique à transmission (MET) de dépôt de bi-métalliques Ag-Rh sur un substrat en silicium réalisées par le procédé selon l'invention dans les conditions de l'exemple 10.

L'échelle représentée sur la figure 17 est de 20 nm.

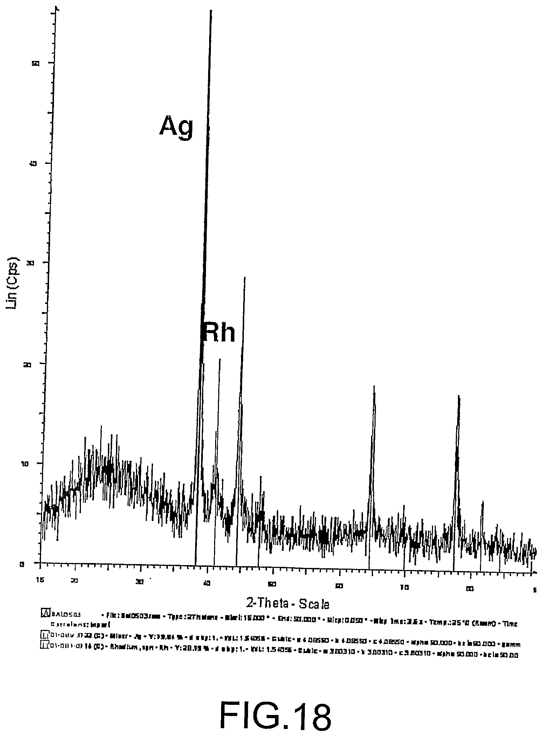

- La figure 18 représente le spectre de diffraction des rayons X du dépôt de bi-métalliques Ag-Rh sur un substrat silicium réalisé par le procédé selon l'invention dans les conditions de l'exemple 10.

En ordonnée est portée Lir (Cps) et en abscisse est porté 2θ.

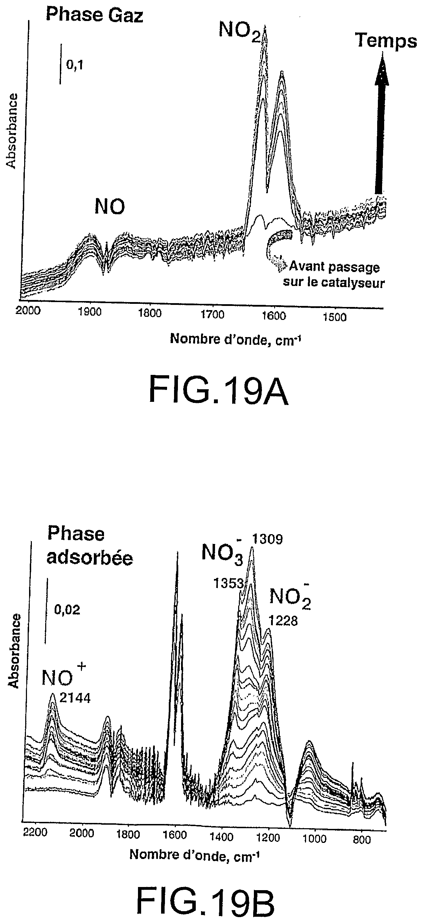

- La figure 19 représente les spectres en FTIR de la phase gaz (19A) et de phase absorbée (19B), lors du traitement d'un flux P_{NO} (1 000 ppm) et PO₂ = 10 % à température ambiante par la surface revêtue de nanoparticules d'argent préparée dans l'exemple 1.

En ordonnée est porté l'absorbance et en abscisse le nombre d'ondes (cm⁻¹).

De manière plus précise, pour la mise en œuvre du procédé selon l'invention, la composition généralement sous forme liquide contenant le ou les précurseurs est généralement envoyée tout d'abord dans un dispositif de vaporisation ou vaporisateur.

La composition contenant le ou les précurseurs, se présente de préférence, comme on l'a indiqué plus haut sous la forme d'une solution du ou des précurseurs dans un solvant, ladite solution comprenant de préférence un nitrile et/ou une amine pour favoriser la dissolution du précurseur dans la solution, le précurseur en question est un précurseur de l'argent.

Le ou lesdits précurseurs sont des composés organométalliques. Par composés organométalliques, on entend également les nitrates de métaux. La solution peut ne contenir qu'un seul précurseur qui est alors, un composé organométallique de l'argent. Si la solution contient plusieurs précurseurs alors l'un de ces précurseurs est un composé organométallique de l'argent, et le ou les autres précurseurs sont des composés organométalliques d'autres métaux différent de l'argent afin de former sur le substrat un alliage de l'argent et de cet autre métal ou de ces autres métaux.

On a vu plus haut que les précurseurs organométalliques préférés aussi bien de l'argent que des autres métaux sont choisis parmi les β-dicétonates et les carboxylates de métaux.

Ainsi, les précurseurs préférés de l'argent seront-ils choisis parmi les β-dicétonates et les carboxylates d'argent. Un précurseur d'argent préféré entre tous est le pivalate d'argent qui permet de s'affranchir des problèmes de faible volatilité rencontrés avec des précurseurs tels que les carboxylates d'argent Ag(O₂CR) où R est un groupe alkyle de préférence de 3 à 7C, et également des problèmes de contamination généralement rencontrés avec les précurseurs organométalliques fluorés.

A la sortie du dispositif de vaporisation, la composition, par exemple la solution, contenant les précurseurs est introduite dans une enceinte qui contient le substrat ou support sur lequel doit être effectué le dépôt.

Le substrat ou support peut avoir une forme quelconque car le procédé selon l'invention permet le dépôt de particules d'argent, même sur des substrats qui présentent une géométrie très complexe. Le substrat peut être choisi parmi les substrats poreux ou parmi les substrats denses, non poreux.

Le substrat peut avoir un état de surface quelconque, il peut être rugueux ou lisse.

La taille du substrat n'est pas limitée, aussi bien des substrats de petite que de grande taille peuvent recevoir un dépôt par le procédé de l'invention.

Le substrat peut être en un matériau quelconque, et même en un matériau relativement sensible à la chaleur grâce aux températures de dépôt relativement faibles utilisées.

Le substrat peut être par exemple en un matériau choisi parmi les céramiques, le silicium, les zéolithes, l'acier, les tissus.

Avant son arrivée dans le dispositif de vaporisation, la composition telle qu'une solution est généralement maintenue dans un réservoir à la température ambiante.

La vaporisation de la composition de précurseur peut être effectuée à l'aide de divers dispositifs connus de l'homme du métier.

A titre d'exemple préféré, on peut citer le dispositif décrit dans Chem. Mat. 13, 3993 (2001), commercialisé par la société Jipelec sous le nom de « InJect, Système d'injection et d'évaporation de précurseurs liquides purs ou sous forme de solutions ». La température du substrat à revêtir qui se confond généralement avec la température dans l'enceinte de dépôt et que l'on peut définir comme étant la température de dépôt est selon l'invention généralement une température relativement basse à savoir inférieure ou égale à 500°C, de préférence inférieure ou égale à 300°C, par exemple de 280°C.

Une telle température basse a l'avantage de permettre le dépôt des particules d'argent sur des substrats thermiquement fragiles ce qui n'aurait pas été possible par d'autres procédés opérant à des températures beaucoup plus élevées.

L'enceinte de dépôt est constituée par un réacteur, réservoir, fermé dans lequel règne une atmosphère constituée par un gaz dit gaz réactionnel comprenant en majorité (en volume), selon l'invention, un gaz réactif oxydant.

A l'intérieur de l'enceinte de dépôt on peut régner la pression atmosphérique ou une pression inférieure à celle-ci (enceinte sous vide) par exemple une pression inférieure ou égale à : 1999.84 Pa (15 Torrs).

Le procédé selon l'invention peut avantageusement être réalisé avec une assistance plasma.

Les techniques d'assistance plasma sont complémentaires des procédés de dépôt chimique en phase vapeur à l'aide de précurseurs organométalliques dans le sens où elles autorisent également de faibles températures de réaction (techniques dites PA ou PE-CVD, à savoir « Plasma Assisted » ou « Plasma Enhanced Chemical Vapour Deposition »).

Le type d'excitation plasma peut être choisi par exemple parmi les excitations au plasma basse fréquence (BF), radiofréquence (RF) ou courant continu pulsé (DC pulsé).

L'assistance plasma permet d'offrir des possibilités supplémentaires de structuration de surfaces.

Un plasma froid peut donc éventuellement être ajouté autour du support. Lorsque le dépôt est effectué en présence de plasma, il est suffisant que le support, substrat, destiné à recevoir les nanoparticules de métal ou d'alliage de métaux, par exemple d'argent ou d'alliage d'argent soit maintenu à la même température qui règne dans l'évaporateur. En l'absence de plasma, il est nécessaire que ledit support soit à une température supérieure à celle de l'évaporateur, la différence de température étant au moins égale à 20°C, de préférence au moins égale à 50°C, afin d'éviter le dépôt d'argent sur les parois du réacteur.

Le changement des énergies de surface et de joint de grains induit par l'utilisation du gaz oxydant, conformément à l'invention, permet d'élaborer des dépôts de nanoparticules d'argent ou d'alliage d'argent, dispersées, par exemple des films discontinus, à des températures de dépôt relativement basses définies ci-dessus.

Comme on l'a déjà indiqué plus haut, le dépôt obtenu par le procédé selon l'invention peut être notamment défini comme un film poreux se présentant sous la forme d'îlots métalliques de taille nanométrique, c'est-à-dire généralement d'une dimension par exemple d'un diamètre de 1 à 400 nm, bien dispersées en surface du substrat, support que ce dernier soit dense ou poreux, ce qui leur confère une grande surface active, élément primordial pour des applications catalytiques par exemple.

La composition, la morphologie et en particulier la porosité des dépôts de nanoparticules d'argent ou de nanoparticules d'alliage d'argent, réalisées par le procédé de l'invention peut être réglée, ajustée, en agissant sur certains paramètres tels que la nature et le débit du gaz réactif, la quantité de précurseur, la température et la pression à la condition toutefois que le gaz en présence duquel est réalisé le dépôt contienne toujours une proportion majoritaire en volume de gaz oxydant, avec notamment un rapport de débits gaz oxydant/gaz inerte >1.

La mise en œuvre du procédé de l'invention permet d'obtenir des nanoparticules à base d'argent, ayant une bonne adhérence sur les supports sur lesquels elles ont été déposées. La taille des nanoparticules varie en fonction des paramètres procédé et notamment en fonction du rapport de débits gaz oxydant/gaz inerte (toujours en restant avec ce rapport >1), du débit de précurseurs de métal et enfin du temps d'expérience. En général, les films sont non conducteurs et présentent visuellement un aspect mat.

Une installation qui convient particulièrement bien à la mise en œuvre du procédé selon l'invention et qui est celle utilisée dans les exemples ci-dessus comprend un dispositif de vaporisation du type « InJect » cité plus haut commercialisé par la société JIPELEC qui est couplé à une enceinte de dépôt chimique en phase vapeur.

Le dispositif « InJect » comprend quatre parties principales :
- le ou les réservoirs de stockage de la ou des solutions chimiques de précurseurs ; dans le cas où les nanoparticules sont constituées par un seul métal, un seul réservoir de stockage est prévu ; dans le cas d'alliages dont la mise en solution des précurseurs organométalliques ne peut être effectuée dans un solvant commun, plusieurs réservoirs de stockage sont utilisés ;
- un ou plusieurs injecteur(s), par exemple du type injecteur de moteur à essence ou diesel relié(s) par une ou plusieurs ligne(s), canalisation(s) d'alimentation au(x) réservoir(s) de stockage(s), de liquide et qui est piloté par un dispositif de commande électronique ;
- une ligne, canalisation d'alimentation en gaz vecteur ou porteur inerte neutre (par exemple l'azote) ;
- et un dispositif de vaporisation (évaporateur).

L'enceinte de dépôt chimique en phase vapeur, qui contient le substrat à revêtir, comprend des moyens de chauffage, une alimentation en gaz réactif oxydant tel que l'oxygène, et des moyens de pompage et de régulation de la pression, réduite si l'on opère sous vide. L'évaporateur est connecté à l'enceinte de dépôt chimique en phase vapeur par une canalisation qui est munie de moyens de chauffage et qui est maintenue à la même température que l'évaporateur.

L'enceinte de dépôt chimique en phase vapeur et le substrat à revêtir qui y est placé sont généralement maintenus à une température supérieure à celle de l'évaporateur afin de créer un gradient thermique positif. La solution chimique contenant un précurseur d'argent est introduite dans le réservoir maintenu sous pression à une pression par exemple de 1 bar ou 2 bars, puis envoyée à partir dudit réservoir, par l'intermédiaire du ou des injecteur(s) (par différence de pression) dans l'évaporateur qui est maintenu sous vide. Le débit d'injection est contrôlé en agissant sur la fréquence et la durée d'ouverture du ou des injecteur(s) que l'on peut considérer comme une microélectrovanne et qui est commandée par un ordinateur.

La réaction chimique se fait en présence d'un gaz réactionnel composé d'un gaz réactif, tel que O₂, H₂ ou CO₂ et sous une pression généralement inférieure ou égale à 2 000 Pa.

Notamment de par la nature chimique (au minimum un métal noble qui est l'argent et éventuellement plusieurs) et la morphologie (grand nombre de sites actifs de taille nanométrique très bien dispersés) des nanomatériaux selon l'invention (c'est-à-dire des substrats sur lesquels se trouvent dispersées des particules nanoélectriques d'argent ou d'alliage d'argent), ils apparaissent des candidats de choix dans les domaines de l'électronique, de l'optique et surtout de la catalyse par exemple pour la protection de l'environnement. A titre d'exemple, ils trouvent ainsi des applications directes pour l'oxydation en phase gazeuse (dépollution de l'air) et l'oxydation en phase aqueuse (dépollution de l'eau), mais ils peuvent également servir en tant que membranes pour la perméation à l'hydrogène (reformage des gaz pour les piles à combustible, hydrogénation/déshydrogénation) ou encore permettre de catalyser d'autres réactions dans le domaine des piles à combustible.

L'invention va maintenant être décrite en référence aux exemples suivants, donnés à titre illustratif et non limitatif.

### Exemples 1 et 2

Dans ces exemples, on réalise le dépôt de particules d'argent sur un substrat céramique poreux constitué par une mousse d'alumine-zircone 20 ppi (« pores par inch ») ou sur un substrat plan constitué par une plaquette « wafer » de silicium.

Les dépôts sont réalisés à l'aide d'un dispositif de vaporisation « InJect » couplé à une enceinte de dépôt comme décrit plus haut.

Les dépôts sont réalisés à partir d'une solution comprenant le précurseur organométallique, pivalate d'argent AgPiV (Ag(tBuCO₂)), dissout dans un solvant qui est le mésitylène auquel est ajouté de la diisopropylamine (iPr₂NH ou [(CH₃)₂CH]₂NH) pour favoriser la mise en solution. La concentration finale en précurseur est de 0,05 mol/1.

Les températures de l'évaporateur et du substrat sont fixées respectivement à 170 et 280°C.

Les autres conditions opératoires de ces deux exemples sont présentées dans le tableau 1 suivant :

**TABLEAU 1**

| | Fréquence injecteur (Hz) | Temps ouverture injecteur (ms) | Débits N₂/O₂ (cc) | Pression (torr) | Temps de dépôt (min) |
|---|---|---|---|---|---|
| Exemple 1 | 2 | 2 | 18/162 | 6,5 | 60 |
| Exemple 2 | 1 | 2 | 36/144 | 8 | 60 |

### Exemple 3 (comparatif)

Dans cet exemple, on réalise à titre de comparaison un dépôt d'argent par la technique de dépôt chimique en phase vapeur (PVD) sur les mêmes substrats que ceux des exemples 1 et 2 et dans les conditions suivantes :
- cible argent : tension de polarisation : -100 V
- : 1 Pa pression
- gaz : argon
- puissance sur cible : 10 W/cm².

### Exemple 4 (comparatif)

Dans cet exemple, on réalise à titre de comparaison un dépôt d'argent par une technique de dépôt chimique en phase vapeur dans les mêmes conditions et avec le même dispositif que dans l'exemple 1 à la seule différence que le dépôt est réalisé sous une atmosphère réductrice constituée de 15% en volume d'hydrogène et 85% en volume d'azote.

### Caractérisation des dépôts réalisés dans les exemples 1 à 4

### - Caractérisation par microscopie électronique à balayage des dépôts des exemples 1 et 2

Dans le cas de l'exemple 1 (figures 1, 2, 3 et 4), on obtient un dépôt composé de nanoparticules d'argent de 50 à 100 nm de diamètre dont certaines ont subi un début de coalescence, ce qui se traduit par la formation d'agrégats de plusieurs centaines de nm de diamètre. La densité des nanoparticules est dans cet exemple proche de 0,3.10¹¹ cm⁻².

Dans le cas de l'exemple 2 (figures 5, 6, 7, 8, 9), on obtient un dépôt composé de nanoparticules d'argent de 5 à 50 nm de diamètre non coalescées ; la densité des nanoparticules est dans ce cas proche de 10¹² cm⁻².

Pour les deux exemples, les dépôts ainsi formés sont adhérents, non conducteurs et cristallisés dans la structure cfc comme le montrent les diagrammes de diffraction des RX des dépôts obtenus, donnés sur la Fig. 10 (en haut : Exemple 1, en bas : Exemple 2).

Par ailleurs, les nanoparticules sont bien dispersées, ceci quelle que soient la nature et la géométrie du substrat, que celui-ci soit plan et en Si ou poreux et en mousse céramique.

Dans le cas du substrat poreux, le dépôt a complètement infiltré la structure avec la présence des nanoparticules à l'intérieur des pores.

### - Caractérisation par spectrométrie d'ions rétrodiffusés (RBS) des dépôts réalisés dans les exemples 1, 2, 3 et 4

Le spectre RBS du dépôt réalisé dans les conditions de l'exemple 1, conformes à l'invention sous une atmosphère oxydante (90% 0₂), présente un pic important d'argent en surface qui va en s'atténuant jusqu'au pic de silicium où les deux pics se chevauchent : ceci permet de dire que le dépôt n'est pas homogène et se présente sous forme d'îlots d'argent laissant une partie de la surface du silicium en contact direct avec le faisceau. La technique de RBS a par ailleurs permis de mettre en évidence une faible contamination de carbone sur l'épaisseur totale du film (de l'ordre du % atomique), cet élément n'est pas détecté dans le cas des dépôts réalisés par PVD. (Exemple 3)

Le dépôt réalisé dans les mêmes conditions que l'exemple 1 mais sous atmosphère réductrice (15% H₂). (Exemple 4) présente un pic caractéristique de l'argent d'une intensité plus faible. Il apparaît plus épais et présente un léger gradient de concentration entre la surface et l'interface et une contamination en carbone plus élevée (de l'ordre de 10% at.). La présence de l'élément carbone est principalement issue de la décomposition des précurseurs et solvants.

N.B. : Un essai a été réalisé avec une proportion minoritaire de 0₂, mais il ne permet pas de caractérisation car il y a trop peu de dépôt.

### Exemple 5

Dans cet exemple, on a testé l'efficacité catalytique des deux dépôts réalisés par OMCVD, avec des atmosphères différentes, dans les exemples 1 (conforme à l'invention) et 4 (non-conforme à l'invention). Cette efficacité catalytique a été testée dans un processus d'oxydation en phase gazeuse, et plus particulièrement sur la réaction d'oxydation du méthanol.

Le dépôt réalisé sous atmosphère réductrice (Exemple 4, non-conforme à l'invention) présentant une activité catalytique nulle, seuls les résultats de l'essai réalisé sous atmosphère oxydante avec le dépôt d'argent réalisé dans l'exemple 1 (selon l'invention) sont présentés (tableaux 2 et 3). Ce résultat est très démonstratif car, contrairement aux catalyseurs usuels à base d'argent qui sont peu dispersés et peu actifs, on constate ici une activité catalytique dès 100°C, résultat comparable à celui généralement obtenu avec un catalyseur au platine qui est un matériau plus rare et plus cher.

Même si la conversion du méthanol n'est que partielle à basse température - ce qui laisse d'ailleurs entrevoir d'autres applications en oxydation sélective telles que par exemple l'époxydation d'oléfines, l'oxydation ménagée d'hydrocarbures, l'oxydation du CO, la décomposition du N₂O, le réformage d'alcools légers tels que le méthanol et l'éthanol - cette conversion montre sans ambiguïté que l'efficacité de ce catalyseur préparé conformément au procédé de l'invention est importante, résultat d'une taille de particules plus faible et donc d'une dispersion bien plus grande.

### Tableaux 2 et 3 : efficacité catalytique dans le processus de conversion du méthanol du film d'argent déposé par OMCVD sur substrat céramique poreux (mousse alumine-zircone, 20 ppi) dans les conditions opératoires de l'exemple 1 (10% N₂, 90% O₂) selon l'invention

**TABLEAU 2**

| Catalyseur | Température (°C) | 100 | 150 | 200 | 250 | 300 |
|---|---|---|---|---|---|---|
| Exemple 1 | Conversion du méthanol (%) | 6 | 74 | 100 | 100 | 100 |
| | Conversion en CO₂ (%) | 0 | 30 | 70 | 100 | 100 |
| | Conversion en CH₃OCH₃ (%) | 0 | 8 | 2 | 0 | 0 |
| | Conversion en CH₂O (%) | 0 | 1 | 1 | 0 | 0 |
| | Conversion en HCOOH (%) | 0 | 26 | 21 | 0 | 0 |

**TABLEAU 3**

| | | | | | |
|---|---|---|---|---|---|
| Exemple 1 | Température de conversion du méthanol | | | Sélectivité en CO₂ | |
| | T₀ | T_{1/2} | T₁ | S_{1/2} | S₁ |
| | | | | | |
| | 100 | 135 | 200 | 0 | 70% |

### Exemples 6 à 10

Dans les exemples de dépôt qui suivent, on réalise le dépôt de nanoparticules de catalyseurs constitués d'un métal : Ag, Rh ou Pt ou d'un alliage de métal Ag/Rh sur un substrat en céramique poreux qui est, par exemple, une mousse alumine-zircone 20 ppi, ou un nid d'abeille alumine-cérine 400 cpsi, ou encore un substrat plan qui est une plaque "wafer" de silicium. Plus précisément, dans l'exemple 6, le substrat est un substrat poreux en mousse de céramique alumine-zircone, 20 ppi, dans l'exemple 7, le substrat est un substrat plan en silicium, dans l'exemple 9 le substrat est un substrat plan en silicium, et dans l'exemple 10 le substrat est un substrat en silicium.

Les dépôts sont réalisés à l'aide d'un dispositif de vaporisation "InJect" couplé à une enceinte de dépôt comme décrit plus haut.

Les dépôts sont réalisés à partir d'une solution chimique comprenant le ou les précurseur(s) organométallique(s). Les solutions chimiques utilisées dans les exemples sont les suivantes :
- pour l'argent : du Pivalate d'Argent AgPiV (Ag (tBuCO₂)), dissout dans un solvant (mésitylène) auquel est ajouté la molécule diisopropylamine (iPr₂NH=[(CH₃)₂CH]₂NH) pour favoriser la mise en solution. La concentration finale en précurseur est de 0,05 mol/l ;
- pour le Palladium : de l'acétylacétonate de Palladium Pd(C₅H₇O₂)₂ dissous à 0,03 mol/l dans l'acétylacétone ;
- pour le Platine : de l'acétylacétonate de platine Pt(C₅H₇O₂)₂ dissous à 0,02 mol/l dans l'acétylacétone ;
- pour le Rhodium : de l'acétylacétonate de Rhodium Rh(C₅H₇0₂)₃ dissous à 0,02 mol/l dans le toluène.

Le choix du solvant est fait en fonction de la nature des précurseurs organométalliques : dans le cas d'alliages métalliques (par exemple, binaire tel que Ag/Rh, ternaire Ag/Pt/Rh) ou encore d'alliages composites métal/oxyde (alcalin ou alcalino-terreux), le solvant peut être commun aux différents précurseurs ou encore différent (vaporisation à partir de plusieurs sources indépendantes de précurseurs).

Les températures de l'évaporateur et du substrat sont fixées respectivement à 200 et 350°C. Les autres conditions opératoires des exemples sont présentées dans le tableau 4 suivant :

**TABLEAU 4**

| Exemple | Précurseurs | Fréquence injecteur(s) (Hz) | Temps ouverture injecteur(s) (ms) | Nature des gaz et débits (cc) | Pression (Pa) | Temps de dépôt (min) |
|---|---|---|---|---|---|---|
| 6 | Argent | 2 | 2 | N₂/O₂=18/162 | 800 | 45 |
| 7 | Argent | 2 | 2 | N₂/O₂=18/162 | 800 | 15 |
| 8 | Rhodium | 2 | 2 | N₂/O₂=40/160 | 400 | 20 |
| 9 | Platine | 2 | 2 | N_{2/}O₂=40/160 | 800 | 20 |
| 10 | Alliage Ag/Rh | Ag : 2 | Ag : 2 | N₂/O₂=40/160 | 400 | 20 |
| | | Rh : 1 | Rh : 2 | | | |

### Caractérisation des dépôts réalisés dans les exemples 6 à 10

- Caractérisation par microscopie électronique à balayage (MEB-FEG) des dépôts réalisés dans les exemples 6, 7 et 9 (figures 14, 15 et 16).

Dans le cas de l'exemple 6, figure 14, on obtient un dépôt composé de nanoparticules d'argent de 50 à 100 nm de diamètre, interdistantes de 40 nm environ, déposé sur un support macroporeux qui est une mousse céramique alumine-zircone 20 ppi. La densité des nanoparticules est dans cet exemple proche de 100 particules/µm². Le taux de chargement en catalyseur estimé par analyse chimique est environ de 0,020 % (soit environ 200 µg/g).

Dans le cas de l'exemple 7, figure 15, on obtient un dépôt composé de nanoparticules d'argent de 20 nm de diamètre, interdistantes de 10 nm environ ; la densité des nanoparticules est dans ce cas proche de 270 particules/µm². Le taux de chargement en catalyseur est environ de 0,010 % (soit environ 100 µg/g).

Dans le cas de l'exemple 9, figure 16, on obtient un dépôt composé de nanoparticules de platine non coalescées ; la densité des nanoparticules est dans ce cas proche de 170 particules/µm². Le taux de chargement en catalyseur est environ de 0,015 % (soit environ 150 pg/g).
- Caractérisation par microscopie électronique à transmission (MET) et par diffraction des rayons X du dépôt réalisé dans l'exemple 10.

Dans le cas de l'exemple 10, figure 17, on obtient un dépôt bimétallique composé de nanoparticules d'argent et de rhodium de 5 à 20 nm de diamètre, interdistantes de 5 à 20 nm environ ; la densité des nanoparticules est dans ce cas proche de 410 particules/µm². Le taux de chargement en catalyseur est environ de 0,035 % (soit environ 350 µg/g). D'après le cliché de diffraction réalisé par Microscopie Electronique à Transmission (17A) ainsi que d'après le diagramme obtenu par diffraction des rayons X (figures 17B et 17C), on a la présence des deux phases métalliques de Ag et de Rh, ce qui est à priori plus favorable en terme de stabilité thermique des catalyseurs.

A la lumière des exemples ci-dessus, on constate que les taux de chargement restent très faibles par rapport à des voies telles que l'imprégnation ou encore sol-gel et qu'ils sont de l'ordre de 0,1 à 0,5 %.

La technique RBS a par ailleurs permis de mettre en évidence une contamination en carbone sur l'épaisseur totale du film de l'ordre du % atomique, élément qui n'est pas détecté dans le cas des films élaborés par imprégnation ou encore sol-gel, suivies des phases de séchage/calcination. La présence de l'élément carbone est principalement issue de la décomposition des précurseurs et solvants.

### Exemple 11

Dans cet exemple, on met en évidence des propriétés des dépôts de l'exemple 6, par caractérisation par infrarouge (FTIR) *in situ* et *operando.*

L'expérience est réalisée sous un flux réactionnel de P_{NO} = 1 000 ppm, et PO₂ = 10 % à température ambiante.

A titre indicatif, des premiers résultats de tests d'adsorption de NO sur une surface recouverte de nanoparticules d'argent issus de ces deux approches expérimentales sont présentés sur les figures 19A et 19B : l'oxydation de NO en NO₂, puis nitrates, révèle la forte capacité oxydante des nanoparticules d'argent, même à température ambiante (espèces réactives intermédiaires susceptibles de se convertir en N₂).

### REFERENCES

[1] N. Myioshi, S. Matsumoto, K. Katoh, T. Tanaka, K. Harada, N. Takahashi, K. Yokota, M. Sugiura, K. Kasahara SAE Technical Papers Series N° 950809 (1995).
[2] M. Richter, R. Eckelt, B. Parlitz, R. Fricke, Appl. Cat. B : Environnemental 151 (1998). 129.
[3] L. Olsson, E. Fridell J. Catal. 210 (2002) 340.

## Revendications

1. Procédé de dépôt de nanoparticules d'argent ou d'un alliage d'argent, dispersées sur un substrat, par dépôt chimique en phase vapeur CVD, à partir d'un ou plusieurs précurseurs organométalliques comprenant au moins un précurseur organométallique de l'argent, dans lequel le dépôt est réalisé en présence d'un gaz comprenant plus de 50% en volume d'un gaz réactif oxydant.

2. Procédé selon la revendication 1, dans lequel l'alliage d'argent est choisi parmi les alliages de l'argent avec au moins un élément choisi parmi les autres métaux, éventuellement oxydés ; et le carbone.

3. Procédé selon la revendication 2, dans lequel l'autre métal est choisi parmi les métaux nobles tels que le platine, le palladium, le rhodium et l'iridium.

4. Procédé selon l'une quelconque des revendications précédentes, dans lequel les nanoparticules sont incluses dans une matrice d'oxyde de métal ou de carbone, ou sont associées à une zéolithe.

5. Procédé selon la revendication 1, dans lequel le gaz comprend plus de 70%, de préférence 100% en volume du gaz réactif oxydant.

6. Procédé selon l'une quelconque des revendications précédentes, dans lequel le gaz réactif oxydant est choisi parmi l'oxygène, le dioxyde de carbone, l'ozone, le protoxyde d'azote N₂O, et leurs mélanges.

7. Procédé selon la revendication 1, dans lequel le gaz est constitué par un mélange du gaz oxydant et d'un gaz inerte.

8. Procédé selon la revendication 7, dans lequel le gaz inerte est choisi parmi l'argon, l'azote, l'hélium, et leurs mélanges.

9. Procédé selon l'une quelconque des revendications 7 et 8, dans lequel le rapport du débit du gaz oxydant sur le débit du gaz inerte est supérieur à 1.

10. Procédé selon l'une quelconque des revendications précédentes, dans lequel lesdits précurseurs organométalliques sont choisis parmi les carboxylates de métaux, et les β-dicétonates de métaux.

11. Procédé selon la revendication 10, dans lequel le précurseur de l'argent est choisi parmi les carboxylates d'argent de formule RCO₂Ag, dans laquelle R représente un groupe alkyle linéaire ou ramifié de 1 à 10 atomes de carbone, de préférence de 3 à 7 atomes de carbone ; et les β-dicétonates d'argent tels que le tétraméthylheptanedionate d'argent.

12. Procédé selon la revendication 11, dans lequel le précurseur de l'argent est le pivalate d'argent.

13. Procédé selon l'une quelconque des revendications précédentes, dans lequel le ou les précurseurs organométalliques sont mis en œuvre sous la forme d'une solution de ces précurseurs dans un solvant organique.

14. Procédé selon la revendication 13, dans lequel la concentration du ou des précurseur(s) dans la solution est de 0,01 à 0,6 mol/l.

15. Procédé selon l'une quelconque des revendications 13 et 14, dans lequel la solution comprend en outre une amine et/ou nitrile.

16. Procédé selon la revendication 15, dans lequel la concentration en volume de l'amine et/ou du nitrile dans la solution est supérieure à 0,1% de préférence de 0,5 à 10%.

17. Procédé selon l'une quelconque des revendications 15 et 16, dans lequel l'amine est choisie parmi les monoamines telles que la n-hexylamine, l'isobutylamine, le disecbutylamine, la triéthylamine, le benzylamine, l'éthanolamine et la diisopropylamine ; les polyamines ; et leurs mélanges.

18. Procédé selon l'une quelconque des revendications 15 et 16, dans lequel le nitrile est choisi parmi l'acétonitrile, le valéronitrile, le benzonitrile et le propionitrile et leurs mélanges.

19. Procédé selon l'une quelconque des revendications 13 à 18, dans lequel le solvant a une température d'évaporation inférieure à la température de décomposition du ou des précurseurs.

20. Procédé selon la revendication 19, dans lequel le solvant est choisi parmi les composés organiques liquides à température ambiante et jusqu'à 200°C dans les conditions normales de pression.

21. Procédé selon la revendication 20, dans lequel le solvant est choisi parmi le mésitylène, le cyclohexane, le xylène, le toluène, le n-octane, l'isopropanol, le tétrahydrofuranne, l'acétylacétone, l'éthanol ; l'eau ; et leurs mélanges.

22. Procédé selon l'une quelconque des revendications précédentes, dans lequel le dépôt est réalisé à une température du substrat inférieure ou égale à 500°C, de préférence inférieure ou égale à 300°C, de préférence encore de 250 à 290°C.

23. Procédé selon l'une quelconque des revendications précédentes, dans lequel le dépôt est réalisé à pression atmosphérique.

24. Procédé selon l'une quelconque des revendications 1 à 22, dans lequel le dépôt est réalisé sous vide, de préférence à une pression de 300 Pa à 1000 Pa.

25. Procédé selon l'une quelconque des revendications précédentes, dans lequel la durée du dépôt est de 2 à 90 minutes, de préférence de 5 à 30 minutes.

26. Procédé selon l'une quelconque des revendications précédentes, dans lequel le dépôt est réalisé avec une assistance plasma.

27. Procédé selon l'une quelconque des revendications précédentes, dans lequel le substrat est choisi parmi les substrats poreux et les substrats denses.

28. Procédé selon l'une quelconque des revendications précédentes, dans lequel le substrat est en un matériau choisi parmi les céramiques telles que l'alumine, la cérine, la zircone ; le silicium ; les zéolithes ; l'acier ; et les tissus.

## Patentansprüche

1. Verfahren zur Abscheidung von Nanopartikeln aus Silber oder einer Silberlegierung, die auf einem Substrat dispergiert sind, durch chemische Dampfphasenabscheidung CVD, ausgehend von einem oder mehreren metallorganischen Vorläufern, die zumindest einen metallorganischen Silbervorläufer enthalten, wobei die Abscheidung unter Vorhandensein eines Gases durchgeführt wird, das mehr als 50 Vol.-% eines oxidierenden reaktiven Gases enthält.

2. Verfahren nach Anspruch 1,
wobei die Silberlegierung ausgewählt ist aus Legierungen von Silber mit zumindest einem Element, ausgewählt aus weiteren, gegebenenfalls oxidierten Metallen; und Kohlenstoff.

3. Verfahren nach Anspruch 2,
wobei das weitere Metall ausgewählt ist aus Edelmetallen wie Platin, Palladium, Rhodium und Iridium.

4. Verfahren nach einem der vorangehenden Ansprüche,
wobei die Nanopartikel in eine Matrix aus Metalloxid oder Kohlenstoff eingebettet sind, oder mit einem Zeolithen assoziiert sind.

5. Verfahren nach Anspruch 1,
wobei das Gas mehr als 70 Vol.-%, vorzugsweise 100 Vol.-%, des oxidierenden reaktiven Gases enthält.

6. Verfahren nach einem der vorangehenden Ansprüche,
wobei das oxidierende reaktive Gas ausgewählt ist aus Sauerstoff, Kohlenstoffdioxid, Ozon, Distickstoffmonoxid N₂O und deren Gemischen.

7. Verfahren nach Anspruch 1,
wobei das Gas aus einem Gemisch von oxidierendem Gas und Inertgas besteht.

8. Verfahren nach Anspruch 7,
wobei das Inertgas ausgewählt ist aus Argon, Stickstoff, Helium und deren Gemischen.

9. Verfahren nach einem der Ansprüche 7 und 8,
wobei das Verhältnis der Durchflussrate des oxidierenden Gases zur Durchflussrate des Inertgases größer als 1 ist.

10. Verfahren nach einem der vorangehenden Ansprüche,
wobei die metallorganischen Vorläufer ausgewählt sind aus Metallcarboxylaten und Metall-β-Diketonaten.

11. Verfahren nach Anspruch 10,
wobei der Silbervorläufer ausgewählt ist aus Silbercarboxylaten der Formel RCO₂Ag, wobei R eine lineare oder verzweigte Alkylgruppe mit 1 bis 10 Kohlenstoffatomen, vorzugsweise 3 bis 7 Kohlenstoffatomen darstellt; sowie aus Silber-β-Diketonaten, wie Silber-Tetramethylheptandionat.

12. Verfahren nach Anspruch 11,
wobei der Silber-Vorläufer Silberpivalat ist.

13. Verfahren nach einem der vorangehenden Ansprüche,
wobei der bzw. die metallorganischen Vorläufer in Form einer Lösung dieser Vorläufer in einem organischen Lösungsmittel eingesetzt werden.

14. Verfahren nach Anspruch 13,
wobei die Konzentration des bzw. der Vorläufer in der Lösung 0,01 bis 0,6 mol/l beträgt.

15. Verfahren nach einem der Ansprüche 13 und 14,
wobei die Lösung ferner ein Amin und/oder Nitril enthält.

16. Verfahren nach Anspruch 15,
wobei die Volumenkonzentration von Amin und/oder Nitril in der Lösung höher als 0,1%, vorzugsweise 0,5 bis 10 %, ist.

17. Verfahren nach einem der Ansprüche 15 und 16,
wobei das Amin ausgewählt ist aus Monoaminen wie n-Hexylamin, Isobutylamin, Disecbutylamin, Triethylamin, Benzylamin, Ethanolamin und Diisopropylamin; Polyaminen; und deren Gemischen.

18. Verfahren nach einem der Ansprüche 15 und 16,
wobei das Nitril ausgewählt ist aus Acetonitril, Valeronitril, Benzonitril und Propionitril und deren Gemischen.

19. Verfahren nach einem der Ansprüche 13 bis 18,
wobei das Lösungsmittel eine Verdampfungstemperatur unterhalb der Zersetzungstemperatur des bzw. der Vorläufer hat.

20. Verfahren nach Anspruch 19,
wobei das Lösungsmittel ausgewählt ist aus organischen Verbindungen, die bei Raumtemperatur und bei bis zu 200°C unter Standarddruckbedingungen flüssig sind.

21. Verfahren nach Anspruch 20,
wobei das Lösungsmittel ausgewählt ist aus Mesitylen, Cyclohexan, Xylol, Toluol, n-Octan, Isopropanol, Tetrahydrofuran, Acetylaceton, Ethanol; Wasser; und deren Gemischen.

22. Verfahren nach einem der vorangehenden Ansprüche,
wobei die Abscheidung bei einer Substrattemperatur von niedriger oder gleich 500°C, vorzugsweise niedriger oder gleich 300°C, weiter bevorzugt bei 250 bis 290°C, erfolgt.

23. Verfahren nach einem der vorangehenden Ansprüche,
wobei die Abscheidung bei atmosphärischem Druck erfolgt.

24. Verfahren nach einem der Ansprüche 1 bis 22,
wobei die Abscheidung unter Vakuum, vorzugsweise bei einem Druck von 300 Pa bis 1000 Pa, erfolgt.

25. Verfahren nach einem der vorangehenden Ansprüche,
wobei die Abscheidungsdauer 2 bis 90 Minuten, vorzugsweise 5 bis 30 Minuten, beträgt.

26. Verfahren nach einem der vorangehenden Ansprüche,
wobei die Abscheidung plasmagestützt erfolgt.

27. Verfahren nach einem der vorangehenden Ansprüche,
wobei das Substrat ausgewählt ist aus porösen Substraten und dichten Substraten.

28. Verfahren nach einem der vorangehenden Ansprüche,
wobei das Substrat aus einem Material, ausgewählt aus Keramiken wie Aluminiumoxid, Ceroxid, Zirkon; Silizium; Zeolithen; Stahl; und Geweben, besteht.

## Claims

1. Process for depositing nanoparticles of silver or of a silver alloy, dispersed on a substrate by chemical vapour deposition (CVD), from one or more organometallic precursors comprising at least one organometallic precursor of silver, in which the deposition is carried out in the presence of a gas comprising more than 50 vol% of a reactive oxidizing gas.

2. Process according to Claim 1, in which the silver alloy is chosen from the alloys of silver with at least one element chosen from the other, optionally oxidized, metals; and carbon.

3. Process according to Claim 2, in which the other metal is chosen from the noble metals such as platinum, palladium, rhodium and iridium.

4. Process according to any one of the preceding claims, in which the nanoparticles are enclosed in a carbon or metal oxide matrix, or are combined with a zeolite.

5. Process according to Claim 1, in which the gas comprises more than 70 vol%, preferably 100 vol% of the reactive oxidizing gas.

6. Process according to any one of the preceding claims, in which the reactive oxidizing gas is chosen from oxygen, carbon dioxide, ozone, nitrous oxide N₂O, and mixtures thereof.

7. Process according to Claim 1, in which the gas consists of a mixture of the oxidizing gas and an inert gas.

8. Process according to Claim 7, in which the inert gas is chosen from argon, nitrogen, helium, and mixtures thereof.

9. Process according to any one of Claims 7 and 8, in which the ratio of the flow rate of the oxidizing gas to the flow rate of the inert gas is greater than 1.

10. Process according to any one of the preceding claims, in which said organometallic precursors are chosen from metal carboxylates and metal β-diketonates.

11. Process according to Claim 10, in which the silver precursor is chosen from silver carboxylates of formula RCO₂Ag, in which R represents a linear or branched alkyl group having 1 to 10 carbon atoms, preferably 3 to 7 carbon atoms; and silver β-diketonates such as silver tetramethylheptanedionate.

12. Process according to Claim 11, in which the silver precursor is silver pivalate.

13. Process according to any one of the preceding claims, in which the organometallic precursor or precursors are used in the form of a solution of these precursors in an organic solvent.

14. Process according to Claim 13, in which the concentration of the precursor(s) in the solution is from 0.01 to 0.6 mol/l.

15. Process according to any one of Claims 13 and 14, in which the solution comprises, in addition, an amine and/or nitrile.

16. Process according to Claim 15, in which the volume concentration of the amine and/or of the nitrile in the solution is greater than 0.1%, preferably from 0.5% to 10%.

17. Process according to any one of Claims 15 and 16, in which the amine is chosen from monoamines such as n-hexylamine, isobutylamine, di-*sec*-butylamine, triethylamine, benzylamine, ethanolamine and diisopropylamine; polyamines; and mixtures thereof.

18. Process according to any one of Claims 15 and 16, in which the nitrile is chosen from acetonitrile, valeronitrile, benzonitrile and propionitrile and mixtures thereof.

19. Process according to any one of Claims 13 to 18, in which the solvent has an evaporation temperature below the decomposition temperature of the precursor or precursors.

20. Process according to Claim 19, in which the solvent is chosen from organic compounds that are liquid at room temperature and up to 200°C under normal pressure conditions.

21. Process according to Claim 20, in which the solvent is chosen from mesitylene, cyclohexane, xylene, toluene, n-octane, isopropanol, tetrahydrofuran, acetylacetone, ethanol; water; and mixtures thereof.

22. Process according to any one of the preceding claims, in which the deposition is carried out at a substrate temperature less than or equal to 500°C, preferably less than or equal to 300°C, more preferably from 250 to 290°C.

23. Process according to any one of the preceding claims, in which the deposition is carried out at atmospheric pressure.

24. Process according to any one of Claims 1 to 22, in which the deposition is carried out under vacuum, preferably at a pressure of 300 Pa to 1000 Pa.

25. Process according to any one of the preceding claims, in which the deposition time is from 2 to 90 minutes, preferably from 5 to 30 minutes.

26. Process according to any one of the preceding claims, in which the deposition is plasma-enhanced.

27. Process according to any one of the preceding claims, in which the substrate is chosen from porous substrates and dense substrates.

28. Process according to any one of the preceding claims, in which the substrate is made of a material chosen from ceramics such as alumina, ceria, zirconia; silicon; zeolites; steel; and fabrics.
